# EUROPEAN PATENT APPLICATION

(11) **EP 1 069 620 A1**
(43) Date of publication of application: **17.01.2001**
(21) Application number: 00305876.5
(22) Date of filing: 12.07.2000
(51) Int. Cl.: H01L 27/115, H01L 21/8247

(54) **A flash memory array**

(30) Priority: 12.07.1999 US 143487 P; 19.06.2000 US 596408
(71) Applicant: Texas Instruments Incorporated, Dallas, Texas 75251 (US)
(72) Inventor: Mehrad, Freidoon, Plano, Texas 75023 (US); Xia, Jie, Plano, Texas 75024 (US); Ambrose, Thomas M., Richardson, Texas 75081 (US)
(74) Representative: Legg, Cyrus James Grahame

(57) **Abstract**

A layout and method for FLASH memory with no SAS process. The layout involves a source contact (91) that connects the source regions of a series of memory cells (11) and forms the source line (24). The source contact is formed using a hard mask insulator layer (100) as a part of the memory cell gate stack (110), (115) which insulates the control gate (18) during source contact (91) formation.

## Description

This invention relates to the field of electronic devices and especially to a layout and method for fabricating a FLASH memory.

Electronic equipment such as televisions, telephones, radios, and computers are constructed using semiconductor components such as integrated circuits, memory chips, and the like. The semiconductor components are constructed from various microelectronic devices, such as transistors, capacitors, diodes, resistors and the like, fabricated on a semiconductor substrate. Each microelectronic device includes a pattern of conductor, semiconductor and insulator regions formed on the semiconductor substrate.

The density of the microelectronic devices on the semiconductor substrate may be increased by decreasing the spacing between each of the various semiconductor devices. The decrease in spacing allows a larger number of such microelectronic devices to be formed on the semiconductor substrate and, as a result, the computing power and speed of the semiconductor component may be greatly improved.

FLASH memory, also known as FLASH EPROM or FLASH EEPROM, is a semiconductor component that is formed from an array of memory cells each of which includes a floating gate transistor. Data can be written to each cell within the array, but the data is erased in blocks of cells. Each cell is a floating gate transistor having a source, drain, floating gate and a control gate. The floating gate uses channel hot-electrons for writing from the drain and uses Fowler-Nordheim tunnelling for erasure from the source. The sources associated with the floating gates in the cells in a row of the array are connected to form a source line.

The floating gate transistors are electrically isolated from one another by an isolation structure. One type of isolation structure used is a LOCal Oxidation of Silicon (LOCOS) structure. LOCOS structures are formed by thermally growing a localized oxidation layer between the cells to electrically isolate the cells. One problem with the LOCOS structure is that the structure includes non-functional areas that waste valuable space on the semiconductor substrate.

Another type of isolation structure used is a Shallow Trench Isolation (STI). STI structures are formed by etching a trench between the cells and filling the trench with a suitable dielectric material. STI structures are smaller than LOCOS structures and allow the cells to be spaced closer together to increase the density of cells in the array. However, STI structures are often not used in FLASH memory due to the difficulty in forming the source line that connects the cells in each row. The source line is formed using a self aligned source (SAS) process. There are a number of issues with the SAS process and its effect on the FLASH memory cell. Some of these issues are:
a) During the SAS etch, half the stack is exposed to the oxide etch resulting in thinning of the polysilicon word line. This thinned word line will lead to problems with subsequent implants performed in the wordline.
b) During the SAS oxide etch, silicon in the moat area next to the source will be etched resulting in a step of a few hundred angstroms in the source silicon area. Subsequent source implants will be at a lower level than the silicon under the stack which will lead to less doping concentration at the surface under the stack, affecting FLASH cell erase performance.
c) Trenching into the exposed silicon area during the SAS etch is believed to be the source of silicon defects that will result in source drain shorts which are a major reliability issue in FLASH memory cells.

The SAS concept and process for forming FALSH memory cells have led to a particular FLASH cell circuit layout in which all memory cells have a drain contact and there is only one source contact for every 16 drain contacts. The cells are linked using the source line formed during the SAS process. The source line adds series resistance to the circuit leading to a deterioration in memory cell performance. In addition to cell performance, the stacked memory cells in this layout scheme have to bend around the source contact leading to problems in scaling the circuit for increased packing densities.

The invention provides a FLASH memory including an array of memory cells each including a drain region and a source region, at a surface of a semiconductor substrate, on opposite sides of a gate stack lying on the semiconductor substrate, the source regions of the memory cells being connected together by a source contact of conductive material lying above the surface of the semiconductor substrate and contacting the source regions.

Preferably, the memory cells are separated from one another by insulating regions in the semiconductor substrate and the source contact lies on the insulating regions.

Preferably, the source contact of conductive material is separated from the gate stacks by insulating material along the sides of the gate stacks.

Preferably, the material of the source contact is a metal and, preferably, a hard mask insulating layer forms the upper layer of each gate stack.

One form of the FLASH memory comprises:
a plurality of memory cells each memory cell comprising a floating gate, an interstitial dielectric on the floating gate, a control gate on the interstitial dielectric, a hard mask insulating layer on the control gate, a source region adjacent to the floating gate and a drain region adjacent to the floating gate and oppositely positioned with respect to the source region and
a source contact comprising a continuous conductive film on the source regions of the plurality of said memory cells wherein the continuous conductive film is substantially parallel to the control gates of the plurality of memory cells.

Another form of the FLASH memory comprises:
a plurality of memory cells each memory cell comprising a floating gate, an interstitial dielectric on said floating gate, a control gate on the interstitial dielectric, a hard mask insulating layer on the control gate, a source region adjacent to the floating gate and a drain region adjacent to the floating gate and oppositely positioned with respect to the source region,
a plurality of insulator regions which electrically isolate the source regions;
a source contact comprising a continuous conductive film on the source regions of the plurality of said memory cells wherein the continuous conductive film is substantially parallel to the control gates of the plurality of memory cells and crosses the plurality of insulator regions.

Preferably, the source contact overlaps the hard mask insulating layer.

The present invention provides a layout and method that eliminate the need for the SAS processes. There are no penalties of added cost or overall process complexity.

The invention provides a method of forming a FLASH memory including the steps of:
fabricating an array of memory cells each including a drain region and a source region, at a surface of a semiconductor substrate, positioned on opposites sides of a gate stack lying on the semiconductor substrate and connecting together the source regions of the memory cells by a source contact of conductive material fabricated on the surface of the semiconductor substrate and contacting the source regions.

Preferably, the method includes the step of fabricating respective insulating regions in the semiconductor substrate separating the memory cells and depositing a metal on the semiconductor substrate and the insulating regions to provide the source contact.

The method may comprise:
providing a semiconductor substrate of a first conductivity type,
forming a gate insulator on the semiconductor substrate,
forming a floating gate conductive layer on the gate insulator,
forming an interstitial dielectric layer on the floating conductive layer,
forming a control gate conductive layer on the interstitial dielectric layer,
forming a hard mask insulating layer on the control gate conductive layer,
etching the hard mask insulating layer, the control gate conductive layer, the interstitial dielectric layer, the floating gate conductive layer and the gate insulator to form a gate stack,
forming a first sidewall structure abutting the gate stack and a second sidewall structure oppositely abutting the gate stack,
doping the semiconductor substrate to form a source region adjacent to the first sidewall structure and a drain region adjacent to the second sidewall structure wherein the source region and the drain region are of a second conductivity type,
forming a conductive source contact film on the source region wherein the conductive source contact film is abutting the first sidewall structure.

The invention provides method that eliminates the need for the SAS process through the use of a hard mask. Resulting from this method is an improved layout scheme that reduces the source line resistance without adding process complexity and cost.

For a more complete understanding of the present invention and the advantages thereof, reference is now made to the following description taken in conjunction with the accompanying drawings, wherein like reference numerals represent like features, in which:
FIGURE 1 is an electrical schematic diagram, in partial block diagram form, of an electronic device which includes a known memory cell array,
FIGURE 2 is a perspective view of a portion of the memory cell array of FIGURE 1,
FIGURE 3 is an enlarged plan view of a portion of the memory cell array of FIGURE 1,
FIGURE 4 is a an enlarged plan view of a portion of a memory cell array in accordance with the present invention,
FIGURES 5A - 5D are cross-section representations of a FLASH memory cell in accordance with the invention illustrating the method of forming the cell,
FIGURE 6 is a transverse cross-section, say, of a FLASH memory cell in accordance with the invention and
FIGURE 7 is a longitudinal cross-section, say, of a FLASH memory cell in accordance with the invention.

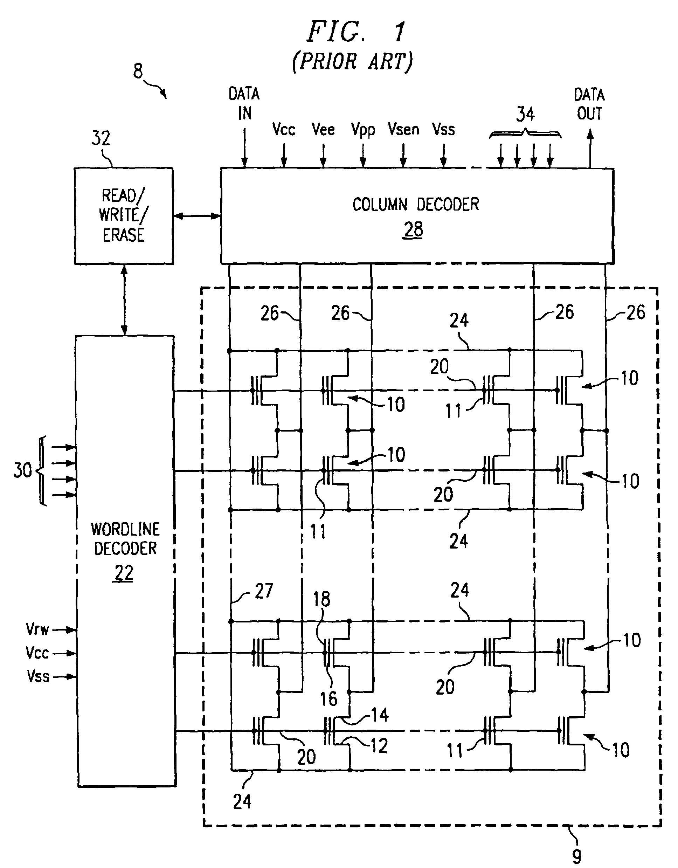

FIGURES 1 through 7 illustrate various aspects of an electronic device and the fabrication of a source line used within the electronic device. As described in greater detail below, the method of the invention can be used to fabricate a source line having a reduced electrical resistance.

FIGURE 1 is an electrical schematic diagram, in partial block form, of a known electronic device 8. The electronic device 8 includes a wordline decoder 22, a column decoder 28, a Read/Write/Erase control circuit 32 for controlling the decoders 22 and 28 and a memory cell array 9. The memory cell array 9 comprises a number of memory cells 10 arranged in rows and columns. Each memory cell 10 includes a floating-gate transistor 11 having a source 12, a drain 14, a floating gate 16 and a control gate 18.

Each of the control gates 18 in a row of cells 10 is coupled to a wordline 20, and each of the wordlines 20 is coupled to the wordline decoder 22. Each of the sources 12 in a row of cells 10 is coupled to a source line 24. Each of the drains 14 in a column of cells 10 is coupled to a drain-column line 26. Each of the source lines 24 is coupled by a column line 27 to the column decoder 28 and each of the drain-column lines 26 is coupled to the column decoder 28.

In a write or program mode, the wordline decoder 22 may function, in response to wordline address signals on lines 30 and to signals from the Read/Write/Erase control circuit 32, to place a preselected first programming voltage V_{RW}, of approximately +12V, on a selected wordline 20 which is coupled to the control gate 18 of a selected cell 10. Column decoder 28 functions to place a second programming voltage V_{PP}, of between approximately +5 to +10V, on a selected drain-column line 26 and, therefore, the drain 14 of the selected cell 10. Source lines 24 are coupled to a reference potential Vss through line 27. All of the deselected drain-column lines 26 are coupled to the reference potential V_{SS}. These programming voltages create a high current (drain 14 to source 12) condition in the channel of the selected memory cell 10, resulting in the generation near the drain-channel junction of channel hot-electrons and avalanche breakdown electrons that are injected across the gate oxide to the floating gate 16 of the selected cell 10. The programming time is selected to be sufficiently long to program the floating gate 16 with a negative program voltage of approximately -2V to -6V with respect to the gate region.

The floating gate 16 of the selected cell 10 is charged with channel hot-electrons during programming, and the electrons in turn render the source-drain path under the floating gate 16 of the selected cell 10 nonconductive, a state which is read as a "zero" bit. Deselected cells 10 have source-drain paths under the floating gate 16 that remain conductive and those cells 10 are read as "one" bits.

In a flash erase mode, the column decoder 28 functions to leave all of the drain-column lines 26 floating. The wordline decoder 22 functions to connect all of the word lines 20 to the reference potential V_{SS}. The column decoder 28 also functions to apply a high positive voltage V_{EE}, of approximately +10V to +15V, to all of the source lines 24. The erasing voltages create sufficient field strength across the tunnelling area between the floating gate 16 and the semiconductor substrate to generate a Fowler-Nordheim tunnel current that transfers charge from the floating gate 16, thereby erasing the memory cell 10.

In the read mode, the wordline decoder 22 functions, in response to wordline address signals on lines 30 and to signals from Read/Write/Erase control circuit 32, to apply a preselected positive voltage V_{CC}, of approximately +5V, to the selected wordline 20 and to apply a low voltage, ground or V_{SS} to the deselected wordlines 20. The column decoder 28 functions to apply a preselected positive voltage V_{SEN}, of approximately +1.0V, to at least the selected drain column line 28 and to apply a low voltage to the source line 24. The column decoder 28 also functions, in response to a signal on an address line 34, to connect the selected drain-column line 26 of the selected cell 10 to the DATA OUT terminal. The conductive or nonconductive state of the cell 10 coupled to the selected drain-column line 26 and the selected wordline 20 is detected by a sense amplifier (not shown) coupled to the DATA OUT terminal. The read voltages applied to the memory array 9 are sufficient to determine channel impedance for a selected cell 10 but are insufficient to create either hot-carrier injection or Fowler-Nordheim tunnelling that would disturb the charge condition of any floating gate 16.

For convenience, a table of read, write and erase voltages is given in TABLE 1 below:

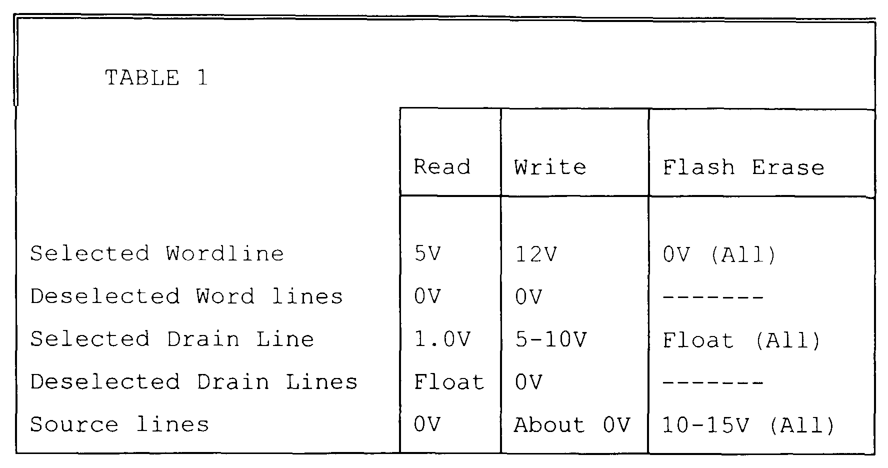

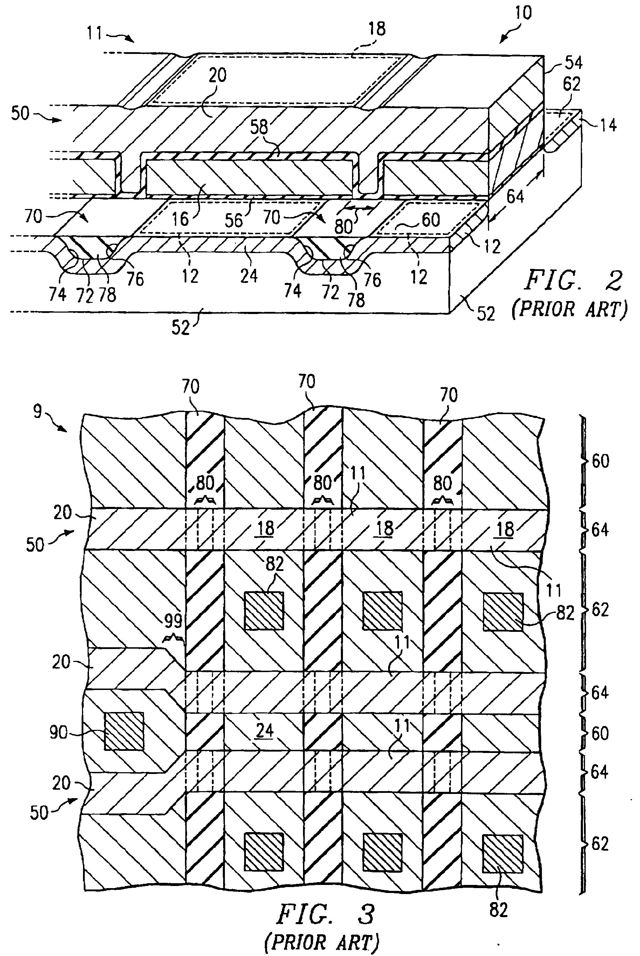

FIGUREs 2 and 3 illustrate the structure of a portion of the memory array 9 illustrated in FIGURE 1. Specifically, FIGURE 2 is a perspective view of a portion of the memory array 9 and FIGURE 3 is an enlarged plan view of a portion of memory array 9. As discussed previously, the memory array 9 includes a number of memory cells 10 arranged in rows and columns.

As is illustrated in FIGURE 2, each row of memory cells 10 is formed from a continuous stack structure 50 that includes a plurality of memory cells 10. The floating gate transistor 11 within each memory cell 10 is formed on a semiconductor substrate 52 and separated from each adjacent memory cell 10 in the continuous stack structure 50 by a shallow trench isolation structure 70. The semiconductor substrate 52 includes a source region 60 and a drain region 62 separated by a channel region 64. The floating gate transistor 11 is fabricated by forming a gate stack 54 outwardly from a portion of the channel region 64 and doping a portion of the source region 60 and a portion of the drain region 62 adjacent to the gate stack 54 to form a source 12 and a drain 14, respectively.

The semiconductor substrate 52 may comprise a wafer formed from a single-crystalline silicon material. For example, the semiconductor substrate 52 may include an epitaxial layer, a recrystallized semiconductor material, a polycrystalline semiconductor material or any other suitable semiconductor material.

The regions 60, 62, and 64 are substantially parallel and may extend the length of the memory array 9. The channel region 64 of the semiconductor substrate 52 is doped with impurities. The channel region 64 of the semiconductor substrate 12 may be doped with p-type or n-type impurities to change the operating characteristics of a microelectronic device (not shown) formed on the doped semiconductor substrate 52.

As is illustrated in FIGURE 2, the floating gate transistors 11 in each continuous stack structure 50 in the memory array 9 are electrically isolated from one another by the shallow trench isolation (STI) structure 70. The STI structures 70 are formed prior to the fabrication of the gate stack 54 on the semiconductor substrate 52. The STI structures 70 are formed by etching a trench 72 into the semiconductor substrate 52. The trench 72 is of the order of 0.2 to 8.5 µm in depth. The trench 72 comprises a first sidewall surface 74 and a second sidewall surface 76.

The trench 72 is then filled with a trench dielectric material 78 to electrically isolate the active regions of the semiconductor substrate 52 between the STI structures 70. The trench dielectric material 78 may comprise silicon dioxide, silicon nitride or a combination thereof. The trench dielectric material 78 is generally etched back, followed by a deglaze process to clean the surface of the semiconductor substrate 52 prior to fabrication of the gate stack 54.

The continuous stack structure 50 is then fabricated outwardly from the semiconductor substrate 52 and the filled trench 72. The continuous stack structure 50 is formed from a series of gate stacks 54 fabricated outwardly from the channel region 64 of the semiconductor substrate 52. As is shown in FIGURE 2, the gate stack 54 comprises a gate insulator 56, the floating gate 16, an interstitial dielectric 58 and the control gate 18. The gate insulator 56 is formed outwardly from the semiconductor substrate 52 and the floating gate 16 is formed outwardly from the gate insulator 56. The interstitial dielectric 58 is formed between the floating gate 16 and the control gate 18 and operates to isolate the floating gate 16 electrically from the control gate 18.

The gate insulator 56 is usually grown on the surface of the semiconductor substrate 52. The gate insulator 56 may comprise oxide or nitride on the order of 25 to 500Å in thickness.

The floating gate 16 and the control gate 18 are conductive regions. The gates 16 and 18 usually comprise a polycrystalline silicon material (polysilicon) that is in-situ doped with impurities to render the polysilicon conductive. The thicknesses of the gates 16 and 18 are of the order of 100 nanometers and 300 nanometers, respectively.

The interstitial dielectric 58 may comprise oxide, nitride or a heterostructure formed by alternating layers of oxide and nitride. The interstitial dielectric 58 is of the order of 5 to 40 nanometers in thickness.

As is illustrated in FIGURE 3, the control gate 18 of each floating gate transistor 11 is electrically coupled to the control gates 18 of adjacent floating gate transistors 11 within adjacent continuous stack structures 50 to form a continuous conductive path. In the context of the memory array 9 discussed with reference to FIGURE 1, the continuous line of control gates 18 operates as the wordline 20 of the memory array 9.

In contrast, the floating gate 16 of each floating gate transistor 11 is not electrically coupled to the floating gate 16 of any other floating gate transistor 11. Thus, the floating gate 16 in each floating gate transistor 11 is electrically isolated from all other floating gates 16. The floating gates 16 in adjacent memory cells 10 are isolated by a gap 80. The gap 80 is etched into a layer of conductive material (not shown) that is used to form the floating gate 16.

As shown in FIGURE 2, the source 12 and the drain 14 of the floating gate transistor 11 are formed within a portion of the source region 60 and the drain region 62 of the semiconductor substrate 52, respectively. The source 12 and the drain 14 comprise portions of the semiconductor substrate 52 into which impurities have been introduced. The drains 14 of each floating gate transistor 11 in a column are electrically coupled to each other by a number of drain contacts 82 to form the drain column line 26 (not shown in Figure 2). The drain column line 26 is generally formed outwardly from the wordline 20. As will be discussed in greater detail below, the source 12 of each floating gate transistor 11 forms a portion of the source line 24 and is formed during the fabrication of the source line 24.

As is illustrated in FIGURE 2, a portion of the source line 24 forms the source 12 of the floating gate transistor 11. The source line 24 connects the sources 12 to each other by a continuous conductive region formed within the semiconductor substrate 52 proximate the source region 60. The source line 24 crosses the STI structures 70 in the source region 60 of the semiconductor substrate 52 below the STI structures 70. In contrast, the STI structures 70 electrically isolate the adjacent floating gate transistors 11 in the channel region 64 of the semiconductor substrate.

The source line 24 and, correspondingly, the sources 12 of each floating gate transistor 11, is generally fabricated after at least a portion of the gate stack 54 has been fabricated. The gate stack 54 is pattern masked (not shown) using conventional photolithography techniques, leaving the semiconductor substrate 52, proximate the source region 60, exposed. The exposed region of the semiconductor substrate 52 is then etched to remove the trench dielectric material 78 in the exposed region. The etching process to remove the trench dielectric material 78 may be an anisotropic etching process. Anisotropic etching may be performed using a reactive ion etch (RIE) process using carbon-fluorine based gases such as CF4 or CHF₃.

The semiconductor substrate 52 proximate the source region 60, including that portion of the semiconductor substrate 52 forming the trench 72, is doped with impurities to render the region conductive. The conductive region is then thermally treated to diffuse the impurities into the source region 60 of the semiconductor substrate 52. The diffused conductive region forms both the source 12 of each floating gate transistor 11 as well as the source line 24. The source region 60 of the semiconductor substrate 52 is usually doped by an implantation process in which dopant ions are impacted into the semiconductor substrate 52. During subsequent processing of the memory array, the trench 72 will be refilled with a dielectric material.

Shown in FIGURE 3 is the source line contact 90. In a typical FLASH memory layout design there is one source contact for every sixteen drain contacts. Because of the spacing of the source line, the word line 20 has to bend 95 around the source contact 90. In addition, for high density designs, the width of the drain region 62 is larger than the width of the source region 60. This results in a non-uniform spacing of the wordlines 20.

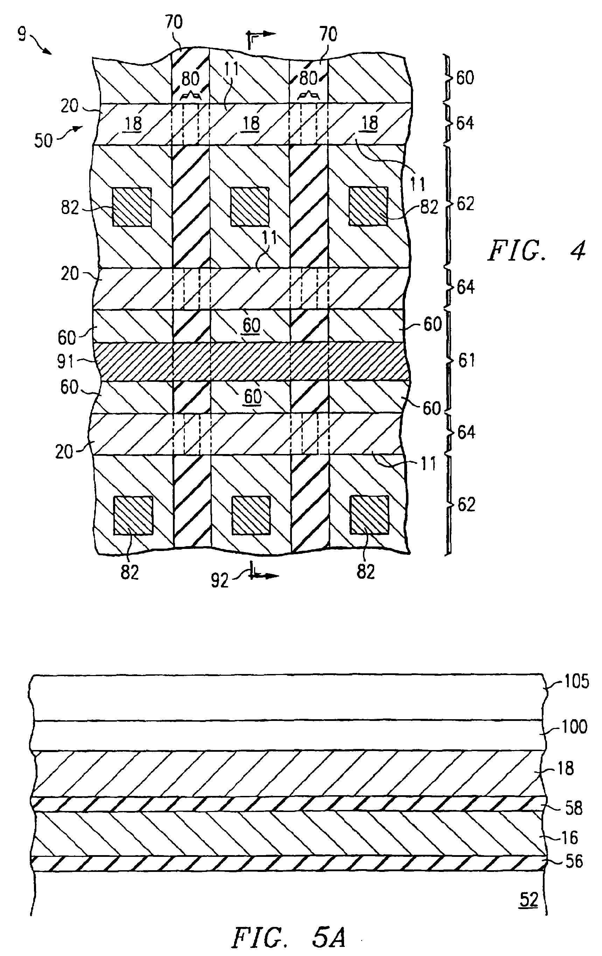

An embodiment of the invention is illustrated in FIGURE 4. Here the width of the drain region 62 is approximately the same as that of the source region 61. In FIGURE 4, each cell has its own drain contact 82. The source line is formed by a straight conductive layer 91 which contacts the source region 60 of each memory cell. For metallization, the landing pads for a first metal layer (not shown) can be placed on top of the drain contacts 82 where they can be connected by a second metal layer (not shown). The source contacts can be effected by the first metal layer at the end of the array and wordline 20 strapping can be effected by a third metal (not shown). It should be noted that there is no SAS etch and the accompanying source implantation and source annealing form the source line 24 shown in FIGURE 3. The source line 24 and the accompanying SAS processes are eliminated in the embodiment of the invention shown in FIGURE 4.

As will be discussed below, the invention uses a hard mask 100 as a part of the memory stack structure 110 and 115. The hard mask 100 allows the cell source 12 and drain 14 spacing to be reduced over previous designs. The reduction in source and drain spacing results in reduced cell area compared to previous designs.

A method for forming the FLASH memory cell shown in FIGURE 4 is illustrated in FIGURES 5A-5D. The FIGURES are cross-sections taken in the plane 92 illustrated in FIGURE 4.

FIGURE 5A shows the floating gate transistor stack before the stack etch process. The semiconductor substrate 52 may comprise a wafer formed from a single-crystalline silicon material. However, it will be understood that the semiconductor substrate 52 may comprise other suitable materials or layers without departing from the scope of the present invention. For example, the semiconductor substrate 52 may include an epitaxial layer, a recrystallized semiconductor material, a polycrystalline semiconductor material or any other suitable semiconductor material. The gate insulator 56 is grown on the surface of the semiconductor substrate 52. The gate insulator 56 may comprise a silicon oxide, nitride or oxynitride film of the order of 25 to 500Å in thickness. It will be understood that the gate insulator 56 may comprise other materials suitable for insulating semiconductor elements. The floating gate 16 and the control gate 18 are conductive regions. The gates 16 and 18 comprise a polycrystalline silicon material (polysilicon) that is in-situ doped with impurities to render the polysilicon conductive. The thickness of the gates 16 and 18 are of the order of 50 - 150 nanometers and 100 - 350 nanometers, respectively. It will be understood that the gates 16 and 18 may comprise other suitable conductive materials without departing from the scope of the invention. The interstitial dielectric 58 may comprise oxide, oxynitride, nitride or a heterostructure formed by alternating layers of oxide, nitride or oxynitride. The interstitial dielectric 58 is of the order of 3 to 40 nanometers in thickness. It will be understood that the interstitial dielectric 58 may comprise other materials suitable for insulating semiconductor elements. The hard mask layer 100 may comprise nitride or phosphosilicate glass (PSG) of the order of 750 - 1500Å thick. It will be understood that the capping layer may comprise other materials suitable for insulating semiconductor elements. The stacks will be formed using photolithography and etching processes. The layer of photoresist 105 shown in FIGURE 5A will be patterned and used as an etch mask. Without the presence of the hard mask 100, the resist layer 105 serves as the etch mask and so a thick film has to be used. Typical thickness for the resist with no hard mask is of the order of 8000Å. The use of the hard mask 100 allows the thickness of the resist layer 105 to be reduced to less than 6000Å. The thinner resist layer 105 provides improved depth of focus during the subsequent photolithography process resulting in an improved process.

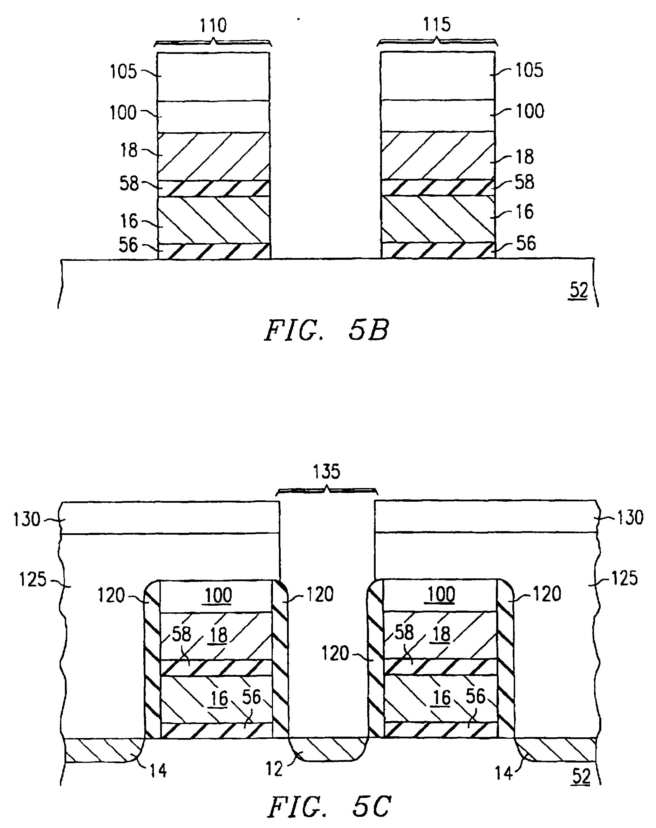

Shown in FIGURE 5B are adjacent gate stack structures 110 and 115 formed after the application of the photolithography and etch processes to the structure of FIGURE 5A. Following the removal of the resist film 105, a number of processes are performed to form the source 12 and drain 14 regions as well as the gate stack sidewall 120 structures shown in FIGURE 5C. The gate stack sidewall structures 120 may comprise nitride, oxide or any other suitable material. The gate stack sidewall structures 120 are fabricated by first forming a film over the entire structure and then applying an anisotropic etch process resulting in the sidewall structures 120 shown in Figure 5C. A dielectric layer 125 is formed as well as a photoresist film 130 which will be used to pattern the dielectric film. The dielectric film 125 may comprise BPSG, PSG or any other suitable insulating planarizing film. The resist film 130 is patterned and the dielectric film etched to form the source contact opening 135 shown in FIGURE 5C. The process used to etch the film 125 should have a high etch selectivity to the hard mask layer 100. Where the hard mask layer 100 is silicon nitride, the control gate and floating gate is polysilicon and the interstitial dielectric is an oxide-nitride-oxide layer structure, a suitable stack etch process is:
i) hard mask etch

| | |
|---|---|
| CHF₃ | 5 - 20 sccm |
| HeO₂ | 2 - 7 sccm |
| CF₄ | 7 - 15 sccm |
| Ar | 50 - 90 sccm |
| Pressure | 20 mTorr |
| Source power | 1000 Watt |
| Bias power | 200 Watt |
| Cathode Temp | 55 °C |
| Wall/Dome Temp | 80/80 °C |
| Etch Time | Endpoint (3875Å wavelength) with 35% over-etch time (can be varied) |

ii) control gate etch

| | |
|---|---|
| HBr | 90 - 105 sccm |
| Cl₂ | 25 - 80 sccm |
| CF₄ | 18 - 26 sccm |
| HeO₂ | 9 - 18 sccm |
| Pressure | 4 mTorr |
| Source power | 550 Watt |
| Bias power | 50 Watt |
| Cathode Temp | 55 °C |
| Wall/Dome Temp | 80/80 °C |
| Etch Time | Endpoint (2880Å wavelength) |

iii) interstitial dielectric etch

| | |
|---|---|
| CHF₃ | 7 - 14 sccm |
| CF₄ | 5 - 9 sccm |
| Ar | 95 sccm |
| Pressure | 6 mTorr |
| Source power | 850 Watt |
| Bias power | 150 Watt |
| Cathode Temp | 55 °C |
| Wall/Dome Temp | 80/80 °C |
| Etch Time | 30 s |

iv) floating gate etch

| | |
|---|---|
| HBr | 130 - 190 sccm |
| HeO₂ | 7 - 10 sccm |
| Pressure | 100 mTorr |
| Source power | 1000 Watt |
| Bias power | 150 Watt |
| Cathode Temp | 55 °C |
| Wall/Dome Temp | 80/80 °C |
| Etch Time | 105s |

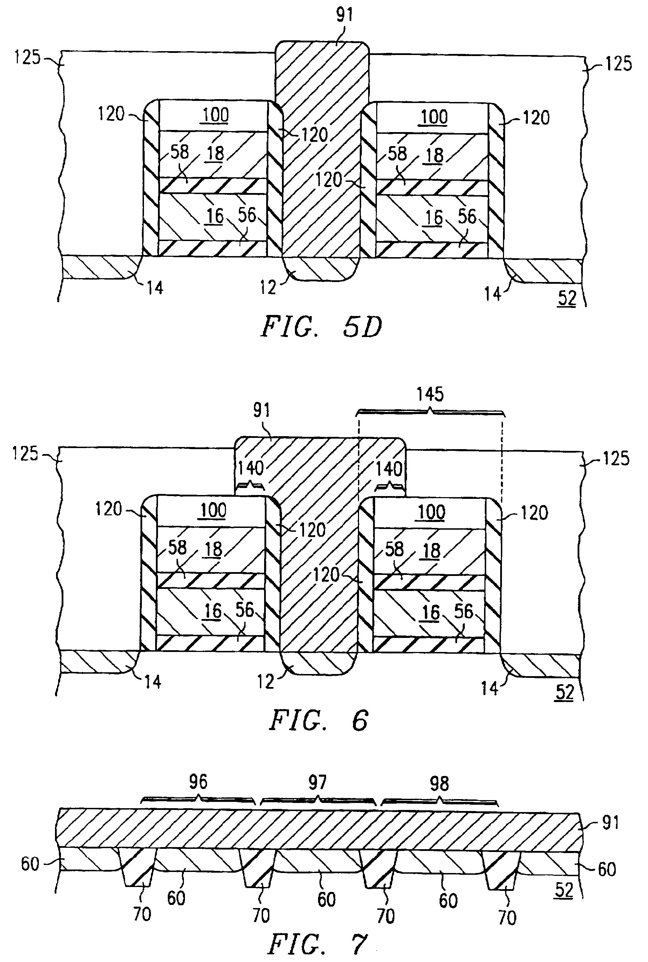

As shown in FIGURE 5D, a conducting layer 91 is formed in the contacting opening 135 in FIGURE 5C to contact the source region 12. This conducting layer 91 can be formed using sputter deposition or other similar techniques. This conducting layer is a continuous layer contacting the source regions of many adjacent memory cells to form the continuous source contact 91 shown in FIGURE 4. This continuous source contact 91 now functions as the source line 24 shown in FIGURE 1. The continuous conducting layer 91 eliminates the need for the SAS etch and implant processes used to form the source line 24 in FIGURE 3. The conducting layer 91 could comprise tungsten, titanium, aluminum, copper or any suitable metal or highly conductive material. The conducting layer could also comprise a stack made up of alternating layers of various metal films such as tungsten, titanium, aluminum, copper or similar materials. The complete FLASH memory circuit can then be completed using conventional processing steps.

FIGURE 6 shows that, for the case where the hard mask layer 100 is silicon nitride, the conductive layer 91 can be formed to overlap 140 a portion of the gate stack as shown. This overlap is formed by increasing the width of the opening 135 shown in FIGURE 5C before the deposition of the conducting layer 91. The region of overlap 140 should typically be less that the width of the gate stack 145. The overlap can be used to reduce the resistance of the source contact line 91 or increase misalignment tolerance during the photolithography process used to form the source contact opening 135.

FIGURE 7 shows a cross-section of the device shown in FIGURE 6 through the plane 93 shown in FIGURE 6. The sections 96, 97, and 98 are memory cells separated by the isolation structures 70. The source regions 12 of the individual memory cells are each contacted by the conducting layer 91 which forms a continuous conducting path.

Although the invention has been described with several embodiments, various changes and modifications may be suggested to one skilled in the art. It is intended that the present invention encompass such changes and modifications that follow within the scope of the appended claims.

## Claims

1. A FLASH memory including an array of memory cells each including a drain region and a source region, at a surface of a semiconductor substrate, on opposite sides of a gate stack lying on the semiconductor substrate, the source regions of the memory cells being connected together by a source contact of conductive material lying above the surface of the semiconductor substrate and contacting the source regions.

2. A FLASH memory as claimed in claim 1, wherein the memory cells are separated from one another by insulating regions in the semiconductor substrate and the source contact of conductive material lies on the said insulating regions.

3. A FLASH memory as claimed in claim or claim 2, wherein the source contact of conductive material is separated from the gate stacks by insulating material along the sides of the gate stacks.

4. A flash memory as claimed in any one of claims 1 to 3, wherein the material of the source contact is a metal.

5. A flash memory as claimed in any one of claims 1 to 4, wherein a hard mask insulating layer forms the upper layer of each gate stack.

6. A FLASH memory as claimed in any one of claims 1 to 5, wherein each memory cell includes two gate stacks and a source region lying between the gate stacks.

7. FLASH memory as claimed in claim 1 comprising:
a plurality of memory cells each memory cell comprising a floating gate, an interstitial dielectric on the floating gate, a control gate on the interstitial dielectric, a hard mask insulating layer on the control gate, a source region adjacent to the floating gate and a drain region adjacent to the floating gate and oppositely positioned with respect to the source region and
a source contact comprising a continuous conductive film on the source regions of the plurality of said memory cells wherein the continuous conductive film is substantially parallel to the control gates of the plurality of memory cells.

8. A FLASH memory as claimed in claim 1, comprising:
a plurality of memory cells each memory cell comprising a floating gate, an interstitial dielectric on said floating gate, a control gate on the interstitial dielectric, a hard mask insulating layer on the control gate, a source region adjacent to the floating gate and a drain region adjacent to the floating gate and oppositely positioned with respect to the source region,
a plurality of insulator regions which electrically isolate the source regions;
a source contact comprising a continuous conductive film on the source regions of the plurality of said memory cells wherein the continuous conductive film is substantially parallel to the control gates of the plurality of memory cells and crosses the plurality of insulator regions.

9. A FLASH memory as claimed in any one of claims 5 to 8, wherein the source contact overlaps the hard mask insulating layer.

10. A FLASH memory as claimed in any one of claims 7 to 9, further including a wordline which is a continuous conductive layer formed by electrically connecting the control gates of a plurality of adjacent memory cells.

11. A FLASH memory as claimed in any one of claims 5 to 10, wherein the hard mask insulating layer is silicon nitride or a phosphosilicate glass.

12. A FLASH memory as claimed in any one of claims 5 to 11, wherein the hard mask insulating layer is less than 3000Å thick.

13. A FLASH memory as claimed in any one of claims 7 to 12, further comprising sidewall structures adjacent to the floating gate, the interstitial dielectric, the control gate, the source region and the drain region of each memory cell.

14. A FLASH memory as claimed in claim 13, wherein the sidewall structures abut the source contact.

15. A FLASH memory as claimed in claim 13 or claim 14, wherein the material of the sidewall structures is silicon nitride, silicon oxide or silicon oxynitride.

16. A method of forming a FLASH memory including the steps of:
fabricating an array of memory cells each including a drain region and a source region, at a surface of a semiconductor substrate, positioned on opposites sides of a gate stack lying on the semiconductor substrate and connecting together the source regions of the memory cells by a source contact of conductive material fabricated on the surface of the semiconductor substrate and contacting the source regions.

17. A method as claimed in claim 16, including the step of fabricating respective insulating regions in the semiconductor substrate separating the memory cells and depositing a metal on the semiconductor substrate and the insulating regions to provide the source contact.

18. A method of forming a FLASH memory as claimed in claim 16, comprising:
providing a semiconductor substrate of a first conductivity type,
forming a gate insulator on the semiconductor substrate,
forming a floating gate conductive layer on the gate insulator,
forming an interstitial dielectric layer on the floating conductive layer,
forming a control gate conductive layer on the interstitial dielectric layer,
forming a hard mask insulating layer on the control gate conductive layer,
etching the hard mask insulating layer, the control gate conductive layer, the interstitial dielectric layer, the floating gate conductive layer and the gate insulator to form a gate stack,
forming a first sidewall structure abutting the gate stack and a second sidewall structure oppositely abutting the gate stack,
doping the semiconductor substrate to form a source region adjacent to the first sidewall structure and a drain region adjacent to the second sidewall structure wherein the source region and the drain region are of a second conductivity type,
forming a conductive source contact film on the source region wherein the conductive source contact film is abutting the first sidewall structure.

19. A method as claimed in claim 18 wherein the material of the hard mask insulating layer is PSG or nitride.

20. A method as claimed in claim 18 or claim 19, wherein the interstitial dielectric is a layered structure with film selected from the group consisting of silicon oxide and silicon nitride.

21. A method as claimed in any one of claims 18 to 20, wherein the material of the first sidewall and the second sidewall structure is silicon nitride.
